# FASCICULE DE BREVET EUROPEEN

(11) **EP 2 264 759 B1**
(45) Date de publication et mention de la délivrance du brevet: **04.07.2012**
(21) Numéro de dépôt: 10165760.9
(22) Date de dépôt: 11.06.2010
(51) Int. Cl.: H01L 23/544, H01L 23/528, H01L 27/08

(54) **Elément d'identification d'une puce de circuit intégré**
Identifizierungselement eines Chips mit integriertem Schaltkreis
Element for identifying an integrated circuit chip

(30) Priorité: 17.06.2009 FR 0954056
(43) Date de publication de la demande: 22.12.2010
(73) Titulaire: STMicroelectronics (Rousset) SAS, 13790 Rousset (FR)
(72) Inventeur: Fornara, Pascal, 83910 Pourrieres (FR); Rivero, Christian, 13080 Luynes (FR)
(74) Mandataire: de Beaumont, Michel

(56) Documents cités:
- EP-A1- 1 341 214
- WO-A1-00/49538

## Description

### Domaine de l'invention

La présente invention concerne de façon générale l'identification de puces de circuit intégré au moyen d'un identifiant qui différencie une puce d'une autre.

### Exposé de l'art antérieur

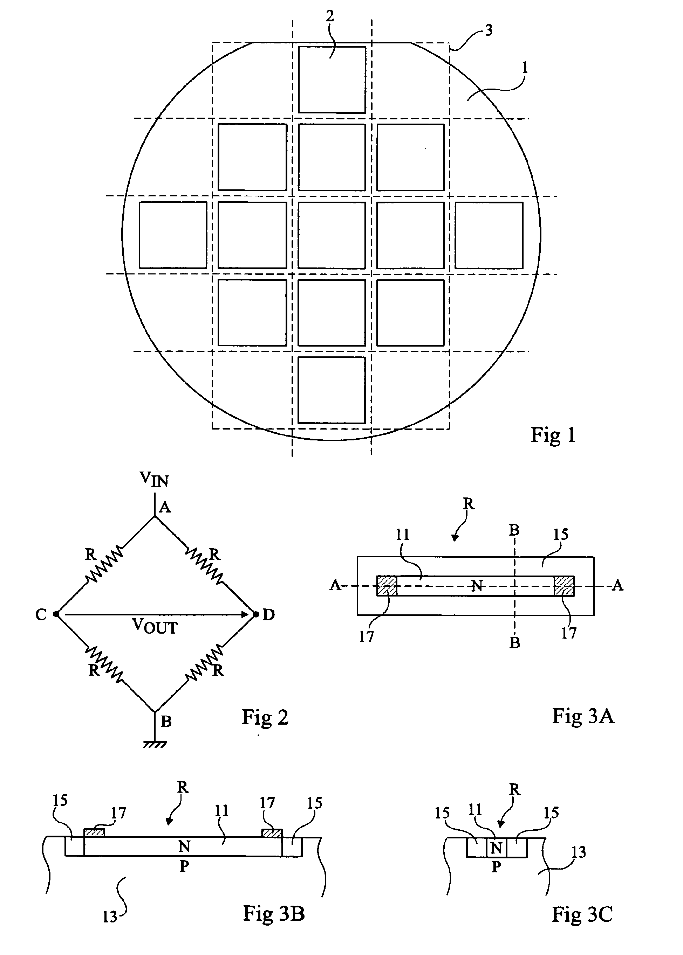

La figure 1 est une vue de dessus schématique d'une plaquette 1 de matériau semiconducteur sur laquelle ont été réalisées des circuits ou puces 2 tous identiques. On fera référence à des puces de circuit intégré, sachant que chaque puce peut comporter un ou plusieurs circuit(s) actif(s) et/ou passif(s). Couramment, un nombre de puces beaucoup plus élevé que ce qui est représenté est réalisé sur une même plaquette. En fin de fabrication, les puces 2 sont individualisées en étant découpées, par exemple au moyen d'une scie, selon des chemins de découpe 3 représentés en pointillés. Dans de nombreuses applications, il est nécessaire de disposer d'un moyen d'identifier de façon unique les puces issues d'un même lot de fabrication. Un tel identifiant est par exemple exploité à des fins de reconnaissance ou de chiffrement dans des dispositifs tels que des cartes de paiement.

Un moyen d'identification consiste, pour chaque puce, à stocker un nombre dans une mémoire non volatile d'un circuit. Cette méthode requiert une étape particulière que ce soit lors de la fabrication (masque d'écriture dans une mémoire ROM) ou après fabrication (processus d'écriture électrique ou optique).

Une autre famille de méthodes consiste à identifier une puce à partir de paramètres physiques dont les valeurs sont liées aux aléas de fabrication. On peut notamment mesurer des paramètres électriques de la puce. Il peut s'agir, par exemple, d'une mesure de tension seuil d'un transistor, d'une mesure de résistance ou d'une mesure de capacité parasite. Ces caractéristiques sont sensibles à des dispersions résultant des imprécisions des technologies de fabrication. On parlera par la suite de dispersions technologiques. Ainsi, on peut considérer que le ou les paramètres pris en compte sont propres à une puce et constituent un identifiant unique. De façon courante, on prévoit dans les puces un grand nombre d'éléments d'identification adaptés à fournir, pour chaque puce, un identifiant unique, à partir de paramètres physiques liés à la fabrication de ces éléments. Les écarts de valeur constituant l'identifiant d'une puce sont par nature très faibles. Ils sont compris dans la marge d'imprécision liée à la fabrication.

Un inconvénient de l'utilisation d'une mesure de paramètres électriques est que ces paramètres sont susceptibles d'évoluer dans le temps, au cours de la vie d'un circuit. Par conséquent, l'identifiant obtenu n'est pas stable. En outre, ces caractéristiques peuvent être sensibles à des dispersions parasites dépendant notamment de la température d'utilisation. Un inconvénient des méthodes basées sur des mesures de paramètres est donc que l'on obtient des identifiants qui peuvent varier d'une mesure à la suivante.

Un élément d'identification d'une puce de circuit intégré est par exemple décrit dans la demande de brevet EP1341214. Cet élément comprend une pluralité de résistances diffusées reliées en pont, la sortie du pont servant d'élément d'identification.

### Résumé

Ainsi, un objet d'un mode de réalisation de la présente invention est de proposer un nouveau moyen d'identification d'une puce à partir de paramètres physiques liés à sa fabrication, palliant au moins certains des inconvénients des moyens d'identification de l'art antérieur.

Un objet d'un mode de réalisation de la présente invention est de proposer un élément d'identification qui soit particulièrement sensible aux dispersions technologiques, tout en étant stable dans le temps et en température.

Un autre objet d'un mode de réalisation de la présente invention est de proposer un tel élément ne nécessitant pas l'ajout d'étapes supplémentaires au procédé de fabrication de la puce.

Ainsi, la présente invention prévoit un élément d'identification d'une puce de circuit intégré, comportant des résistances diffusées identiques reliées en un pont de Wheatstone, dans lequel le circuit intégré est recouvert d'un empilement de niveaux d'interconnexion et de couches isolantes, lesdites résistances étant recouvertes seulement d'isolant, au moins jusqu'au niveau suivant le niveau d'interconnexion le plus proche du circuit intégré.

Selon un mode de réalisation de la présente invention, les résistances diffusées sont entourées d'une région d'isolement.

Selon un mode de réalisation de la présente invention, les résistances diffusées sont en forme de barreaux.

De plus la présente invention prévoit un circuit de génération d'un numéro d'identification d'une puce de circuit intégré comprenant une pluralité de tels éléments d'identification susmentionnés.

Selon un mode de réalisation de la présente invention, ce circuit de génération comprend une pluralité de comparateurs, chaque comparateur comparant les valeurs de déséquilibre de deux ponts de Wheatstone, le numéro d'identification étant constitué à partir des valeurs de sortie des comparateurs.

Selon un mode de réalisation de la présente invention, dans lequel les comparateurs ont deux états de sortie, la sortie de chaque comparateur détermine un bit du numéro d'identification.

### Brève description des dessins

Ces objets, caractéristiques et avantages, ainsi que d'autres seront exposés en détail dans la description suivante faite à titre non-limitatif en relation avec les figures jointes parmi lesquelles :
la figure 1 est une vue de dessus schématique d'une plaquette de matériau semiconducteur sur laquelle ont été réalisées des puces de circuits intégrés ;
la figure 2 représente le schéma électrique d'un élément d'identification d'une puce de circuit intégré ;
les figures 3A à 3C sont des vues de dessus et en coupe schématiques représentant un exemple de résistances constitutives de l'élément d'identification de la figure 2 ;
les figures 4A et 4B sont des vues en coupe schématiques illustrant des exemples d'une partie de l'élément d'identification de la figure 2 ;
les figures 5 et 6 illustrent la dispersion technologique et le comportement dans le temps des exemples de l'élément d'identification de la figure 2 représentés par les figures 4B et 4A ; et
la figure 7 illustre la dispersion technologique et le comportement dans le temps d'un exemple de pont de Wheatstone à résistances diffusées au dessus desquelles ont été maintenues des lignes de silicium polycristallin de grille.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle. Seuls les éléments qui sont nécessaires à la compréhension de l'invention ont été représentés aux figures et seront décrits par la suite. En particulier, la destination et l'exploitation faite de l'identifiant produit n'ont pas été détaillées.

La figure 2 représente le schéma électrique d'un pont de Wheatstone constitué de quatre résistances R identiques. A une première diagonale du pont, entre des noeuds A et B, est appliquée une première tension V_{IN}. A une deuxième diagonale du pont, entre des noeuds C et D, apparaît une éventuelle tension de déséquilibre V_{OUT}.

Les résistances étant de même valeurs, le pont de Wheatstone est normalement équilibré et la tension de sortie V_{OUT} est égale à 0 V quelle que soit la valeur de V_{IN}. Toutefois, en pratique, les résistances ne sont jamais strictement identiques, et le pont n'est jamais strictement équilibré. La tension de sortie V_{OUT} est alors différente de 0 V.

Des ponts de Wheatstone tels que décrits ci-dessus sont utilisés comme éléments d'identification d'une puce. On réalise dans chaque puce un circuit d'identification comprenant un ensemble de ponts de Wheatstone identiques. Les résistances constitutives des ponts étant sensibles aux dispersions technologiques, lorsqu'on applique une même tension d'entrée V_{IN} à tous les ponts on observe que les tensions de sortie V_{OUT} ne sont pas toutes identiques. Ainsi, le jeu des valeurs de déséquilibre V_{OUT} de l'ensemble des ponts est propre à la puce et constitue son identifiant. On prévoit par exemple un circuit d'identification comportant 100 à 200 ponts de Wheatstone identiques pour générer l'identifiant d'une puce.

De nombreux moyens, non représentés, pourront être utilisés pour déduire un identifiant des valeurs de déséquilibre des ponts. Selon un mode de réalisation, on prévoit un ensemble de comparateurs à deux états de sortie, chaque comparateur comparant les tensions V_{OUT} de sortie de deux ponts distincts. La sortie de chaque comparateur détermine un bit spécifique d'un numéro d'identification de la puce. Toutefois, l'invention ne se restreint pas à ce seul cas particulier. L'homme de l'art saura mettre en oeuvre le fonctionnement recherché quel que soit le moyen employé pour générer un numéro d'identification à partir des valeurs de déséquilibre des ponts.

Un avantage de l'utilisation des ponts de Wheatstone comme élément d'identification réside dans le fait que la tension de sortie V_{OUT} est indépendante de la température du circuit. En effet, bien que les valeurs des résistances soient susceptibles de varier avec la température, la dérive subie est la même pour toutes les résistances d'un même pont. Ainsi, l'équilibrage reste inchangé. L'identifiant de la puce est donc stable en température.

Pour obtenir de bonnes performances d'identification, il faut que les ponts de Wheatstone soient sensibles aux dispersions technologiques, tout en étant stables dans le temps.

La figure 3A est une vue de dessus représentant de façon schématique un exemple d'une résistance R constitutive du pont de Wheatstone de la figure 2. Les figures 3B et 3C sont des vues en coupe représentant de façon schématique la résistance R de la figure 3A selon les axes A-A et B-B représentés en traits pointillés. La résistance R est une résistance diffusée. Une zone résistive 11 dopée de type N est formée dans la partie supérieure d'un substrat semiconducteur 13 faiblement dopé de type P. En vue de dessus, la zone 11 a la forme d'un barreau rectangulaire. Une région d'oxyde 15 est disposée en périphérie de la zone 11 pour isoler la résistance R du reste du circuit. Des plots conducteurs 17 sont disposés à la surface du substrat, en contact avec les extrémités de la zone résistive 11.

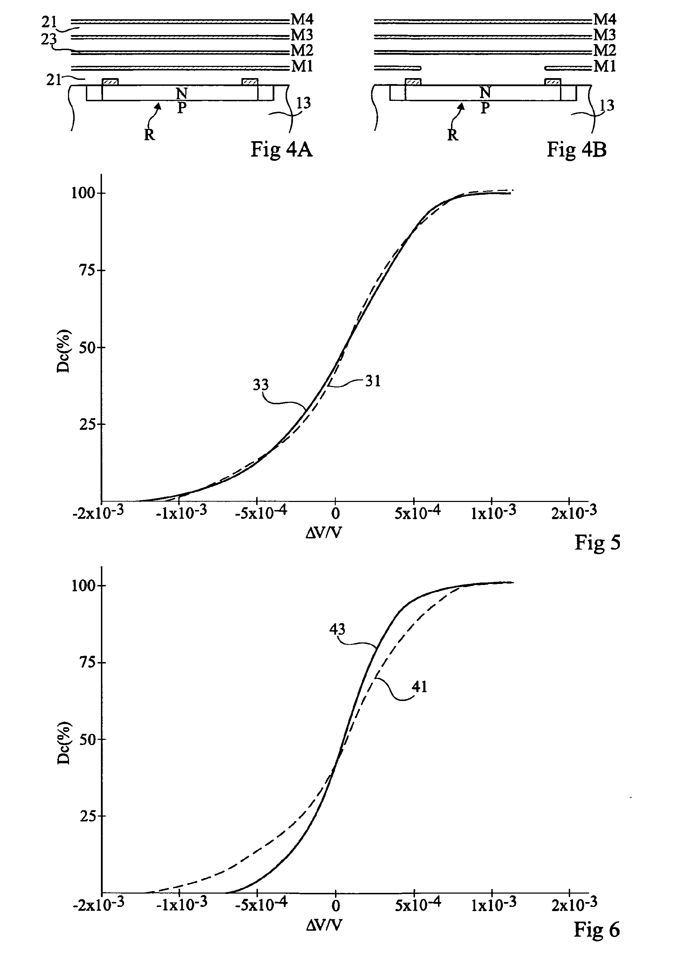

La figure 4A est une vue en coupe représentant de façon schématique une partie d'une puce de circuit intégré comportant une résistance diffusée R telle que celle décrite en relation avec les figures 3A à 3C. La Figure 4A constitue un exemple comparatif ne faisant pas partie de l'invention. De façon courante, le substrat semiconducteur 13 de la puce est recouvert d'un empilement de couches isolantes 21. Des pistes conductrices d'interconnexion 23 sont formées entre les couches isolantes. Il existe généralement plusieurs niveaux d'interconnexion successifs, quatre, M1 à M4, dans l'exemple représenté, les niveaux M1 et M4 étant respectivement le niveau le plus proche et le niveau le plus éloigné du substrat 13. Des vias conducteurs non représentés traversent les couches isolantes pour relier les pistes conductrices entre elles, à des bornes d'entrée-sortie de la puce, et à des composants du circuit intégré, réalisant ainsi les interconnexions du circuit.

La figure 4B est une vue en coupe représentant une réalisation selon l'invention d'une puce de circuit intégré comportant des résistances diffusées R telles que décrites en relation avec les figures 3A à 3C. La figure 4B diffère de la figure 4A uniquement par l'agencement des pistes métalliques d'interconnexion. Les pistes d'interconnexions sont agencées de façon que la résistance R soit recouverte uniquement d'isolant, au moins jusqu'au niveau d'interconnexion M2.

La figure 5 illustre la dispersion technologique et le comportement dans le temps d'un exemple de pont de Wheatstone à résistances diffusées formées selon le mode de réalisation décrit en relation avec la figure 4B. Les inventeurs ont effectué des mesures de déséquilibre sur des ponts de Wheatstone identiques d'un grand nombre de puces d'un même lot de fabrication.

La courbe 31, en pointillés, représente la distribution cumulée Dc en fonction des déséquilibres relatifs des ponts, ΔV/V ou ΔI/I, V et I étant respectivement la tension et le courant appliqués. Il s'agit d'une distribution gaussienne dont l'écart type est de l'ordre de 10⁻⁴ dans cet exemple particulier.

La courbe 33, en traits pleins, correspond à la même mesure effectuée sur le même lot de puces, 15 mois plus tard. On observe que l'écart entre deux points correspondant des courbes 31 et 33 est extrêmement faible.

Ainsi, les ponts de Wheatstone dont les résistances diffusées sont recouvertes uniquement d'isolant jusqu'au niveau d'interconnexion M2 présentent une bonne dispersion technologique et une grande stabilité dans le temps.

La figure 6 illustre la dispersion technologique et le comportement dans le temps d'un exemple de pont de Wheatstone à résistances diffusées formées selon l'exemple décrit en relation avec la figure 4A. Les inventeurs ont effectué des mesures de déséquilibre sur des ponts de Wheatstone identiques d'un grand nombre de puces d'un même lot de fabrication.

La courbe 41, en pointillés, représente la distribution cumulée Dc en fonction des déséquilibres relatifs des ponts, ΔV/V ou ΔI/I. Il s'agit d'une distribution gaussienne.

La courbe 43, en traits pleins, correspond à la même mesure effectuée sur le même lot de puces, 15 mois plus tard. Il s'agit toujours d'une distribution gaussienne d'écart type similaire à celui des courbes de la figure 5. Cependant, on observe que la forme de la distribution a évolué.

Ainsi, on note que la stabilité temporelle des ponts de Wheatstone à résistances diffusées se dégrade lorsque les résistances sont recouvertes par des pistes métalliques dès le premier niveau d'interconnexion M1. Il n'est donc pas souhaitable d'utiliser ce type de pont de Wheatstone pour identifier une puce.

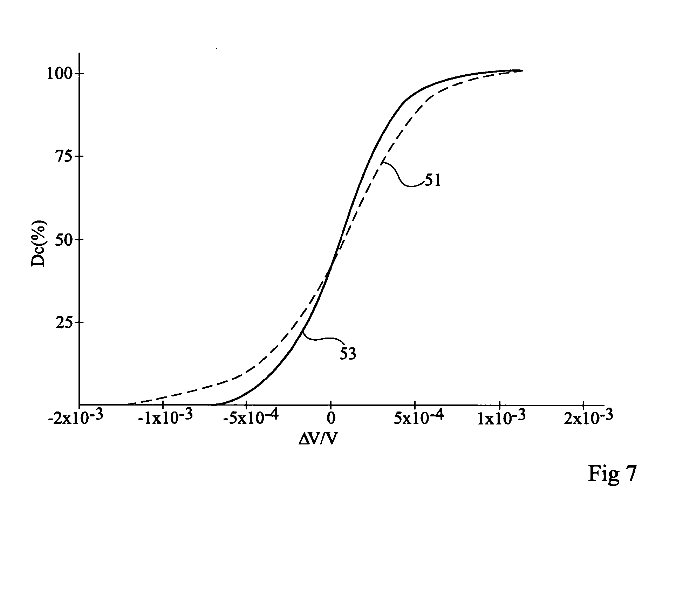

La figure 7 illustre la dispersion technologique et le comportement dans le temps d'un exemple de pont de Wheatstone à résistances diffusées au dessus desquelles ont été maintenues des lignes de silicium polycristallin de grille.

La courbe 51, en pointillés, représente la distribution cumulée Dc en fonction des déséquilibres relatifs des ponts, ΔV/V ou ΔI/I. Il s'agit d'une distribution gaussienne dont l'écart type est de l'ordre de 10⁻⁴ dans cet exemple particulier.

La courbe 53, en traits pleins, correspond à la même mesure effectuée sur le même lot de puces, 15 mois plus tard. Il s'agit toujours d'une distribution gaussienne d'écart type de l'ordre de 10⁻⁴. Cependant, on observe que l'écart maximal entre deux points correspondants des courbes 51 et 53 est important. La forme de la distribution a évolué.

Ainsi, on note que les ponts de Wheatstone à résistances en silicium polycristallin présentent une bonne dispersion mais ne sont pas stables dans le temps. Il n'est donc pas souhaitable d'utiliser ce type de pont de Wheatstone pour identifier une puce.

Les inventeurs ont mis en évidence par de nombreux essais portant sur différentes structures de résistances que les ponts de Wheatstone à résistances diffusées recouvertes uniquement d'isolant, au moins jusqu'au deuxième niveau de métallisation en partant du substrat (M2), sont les plus stables dans le temps. De tels ponts présentent en outre une bonne dispersion technologique.

Selon un aspect d'un mode de réalisation de l'invention, il est prévu dans chaque puce un circuit d'identification composé d'un ensemble de ponts de Wheatstone, les résistances constitutives des ponts étant des résistances du type décrit précédemment.

Selon un avantage d'un mode de réalisation de l'invention, la solution proposée est compatible avec les procédés de fabrication usuels et ne nécessite pas d'étapes de fabrication supplémentaires.

Des modes de réalisation particuliers de la présente invention ont été décrits. Diverses variantes et modifications apparaîtront à l'homme de l'art. En particulier, les résistances constitutives des ponts de Wheatstone du circuit d'identification proposé, décrites en relation avec les figures 3A à 3C, 4A et 4B sont formées dans un substrat de type P. L'homme de l'art saura mettre en oeuvre le fonctionnement recherché dans le cas où les résistances sont formées dans un substrat de type N. En outre, dans la présente description, il est proposé de mesurer le déséquilibre de ponts de Wheatstone par des mesures de tension aux bornes de diagonales des ponts. L'homme de l'art saura mettre en oeuvre le fonctionnement recherché en mesurant le déséquilibre par des mesures d'intensité de courant.

## Revendications

1. Élément d'identification d'une puce (2) de circuit intégré, comportant des résistances diffusées (R) identiques reliées en un pont de Wheatstone, dans lequel le circuit intégré est recouvert d'un empilement de niveaux d'interconnexion (M1 à M4) et de couches isolantes (21), lesdites résistances étant recouvertes seulement d'isolant, au moins jusqu'au niveau suivant le niveau d'interconnexion le plus proche du circuit intégré.

2. Élément d'identification selon la revendication 1, dans lequel lesdites résistances diffusées (R) sont entourées d'une région d'isolement (15).

3. Élément d'identification selon l'une quelconque des revendications 1 à 2, dans lequel lesdites résistances diffusées sont en forme de barreaux.

4. Circuit de génération d'un numéro d'identification d'une puce de circuit intégré comprenant une pluralité d'éléments d'identification selon l'une quelconque des revendications 1 à 3.

5. Circuit de génération d'un numéro d'identification selon la revendication 4, comprenant une pluralité de comparateurs, chaque comparateur comparant les valeurs de déséquilibre de deux ponts de Wheatstone, ledit numéro d'identification étant constitué à partir des valeurs de sortie des comparateurs.

6. Circuit de génération d'un numéro d'identification selon la revendication 5, dans lequel les comparateurs ont deux états de sortie, la sortie de chaque comparateur déterminant un bit dudit numéro d'identification.

## Claims

1. An element for identifying an integrated circuit chip (2), comprising identical diffused resistors (R) connected as a Wheatstone bridge, wherein the integrated circuit is covered with a stack of interconnect levels (M1 to M4) and of insulating layers (21), said resistors being only covered with insulator, at least up to the level following the interconnect level closest to the integrated circuit.

2. The identification element of claim 1, wherein the diffused resistors (R) are surrounded with an insulating region (15).

3. The identification element of claim 1 or 2, wherein said diffused resistors are bar-shaped.

4. A circuit for generating an identification number of an integrated circuit chip comprising a plurality of identification elements of any of claims 1 to 3.

5. The circuit for generating an identification number of claim 4, comprising a plurality of comparators, each comparator comparing the imbalance values of two Wheatstone bridges, the identification number being formed from the output values of the comparators.

6. The circuit for generating an identification number of claim 5, wherein the comparators have two output states, the output of each comparator determining a bit of the identification number.

## Patentansprüche

1. Ein Element zum Identifizieren eines integrierten Schaltungschips (2) welches identische diffundierte Widerstände (R) aufweist, die als eine Wheatstone-Brücke geschaltet sind,
wobei die integrierte Schaltung mit einem Stapel von Zwischenverbindungsniveaus (M1 bis M4) und Isolierschichten (21) bedeckt ist, wobei die erwähnten Widerstände nur mit Isolator bedeckt sind, und zwar mindestens bis zu dem Niveau folgend auf das Zwischenverbindungsniveau am dichtesten zu der integrierten Schaltung.

2. Das Identifikationselement nach Anspruch 1, wobei die diffundierten Widerstände (R) mit Isolationszonen (15) umgeben sind.

3. Das Identifikationselement nach Anspruch 1 oder 2, wobei die erwähnten diffundierten Widerstände stangenförmig sind.

4. Eine Schaltung zur Erzeugung einer Identifikationszahl eines integrierten Schaltungschips, wobei eine Vielzahl von Identifikationselementen nach einem der Ansprüche 1 bis 3 vorgesehen ist.

5. Die Schaltung zur Erzeugung einer Identifikationszahl nach Anspruch 4, wobei eine Vielzahl von Komparatoren vorgesehen ist, wobei jeder Komparator die Ungleichgewichtswerte von zwei Wheatstone-Brücken vergleicht, wobei die Identifikationszahl aus den Ausgangswerten der Komparatoren gebildet wird.

6. Die Schaltung zur Erzeugung einer Identifikationszahl nach Anspruch 5, wobei die Komparatoren zwei Ausgangszustände besitzen, wobei der Ausgang jedes Komparators ein Bit der Identifikationszahl bestimmt.
